(19) Europäisches Patentamt
European Patent Office
Office européen des brevets

(11) **EP 0 731 986 B1**

(12) **EUROPÄISCHE PATENTSCHRIFT**

(45) Veröffentlichungstag und Bekanntmachung des Hinweises auf die Patenterteilung:
**04.03.1998 Patentblatt 1998/10**

(21) Anmeldenummer: **95931122.6**

(22) Anmeldetag: **25.09.1995**

(51) Int Cl.⁶: **H01L 39/16**, H02H 9/02

(86) Internationale Anmeldenummer:
**PCT/CH95/00215**

(87) Internationale Veröffentlichungsnummer:
**WO 96/10269 (04.04.1996 Gazette 1996/15)**

(54) **VORRICHTUNG ZUR STROMBEGRENZUNG**

CURRENT-LIMITING DEVICE

LIMITEUR DE COURANT

(84) Benannte Vertragsstaaten:
**AT BE CH DE DK ES FR GB GR IT LI NL PT SE**

(30) Priorität: **29.09.1994 DE 4434819**

(43) Veröffentlichungstag der Anmeldung:
**18.09.1996 Patentblatt 1996/38**

(73) Patentinhaber: **ABB RESEARCH LTD.**
**8050 Zürich (CH)**

(72) Erfinder:
• **BAUMANN, Thomas**
**CH-5430 Wettingen (CH)**
• **PAUL, Willi**
**CH-5430 Wettingen (CH)**
• **RHYNER, Jakob**
**CH-8037 Zürich (CH)**

(74) Vertreter: **Rzehak, Herbert et al**
**Asea Brown Boveri AG**
**Immaterialgüterrecht(TEI)**
**Haselstrasse 16/699 I**
**5401 Baden (CH)**

(56) Entgegenhaltungen:
EP-A- 0 315 976          EP-A- 0 345 767
JP-A- 2 183 915

• **PATENT ABSTRACTS OF JAPAN vol. 015 no.
054 (E-1031) ,8.Februar 1991 & JP,A,02 281765
(FURUKAWA ELECTRIC CO LTD:THE)
19.November 1990,**

**Beschreibung**

TECHNISCHES GEBIET

Bei der Erfindung wird ausgegangen von einer Vorrichtung zur Strombegrenzung nach dem Oberbegriff des Patentanspruchs 1.

STAND DER TECHNIK

Mit dem Oberbegriff des Patentanspruchs 1 nimmt die Erfindung auf einen Stand der Technik Bezug, wie er aus der JP 2-183915 A bekannt ist. Dort steht ein ebenflächiges Trägersubstrat über mindestens eine seiner beiden Hauptflächen über eine $0{,}01\ \mu m$ - $10\ \mu m$ dicke Schicht aus einem Edelmetall, wie z. B. Silber, die als chemische Barriere dient, mit einem Leiterverbund aus einem Hochtemperatursupraleiter und einem Edelmetall in flächenhaftem Kontakt. Die Schichtdicke des Hochtemperatursupraleiters liegt im Bereich vom $0{,}1\ \mu m$ - $1\ mm$. Das Trägersubstrat kann ein metallischer Leiter sein. Ohne besondere geometrische Gestaltung, insbesondere bei Verwendung eines metallisch leitenden Trägersubstrates, ist diese Hochtemperatursupraleiteranordnung zur Begrenzung von Wechselströmen wenig geeignet.

Aus der US-A-4,961,066 (EP-A-0 345 767) ist es bekannt, zur schnellen Strombegrenzung bei Kurzschlüssen als Strombegrenzer einen stabförmigen, einen rohrförmigen und einen ebenflächigen Schichtaufbau, jeweils aus einem Träger-Isolator, einer flächenhaft darauf aufgebrachten dünnen supraleitenden Schicht sowie einer auf dieser flächenhaft aufgebrachten Widerstandsschicht eines Normalleiters, vorzusehen. Die letzten beiden Schichten können sich aufeinanderfolgend wiederholen.

Dabei ist der Widerstand des nicht supraleitenden Widerstandes kleiner als derjenige des Supraleiters im normalleitenden Zustand. Nachteilig sind große Energieverluste bei Wechselstrombetrieb sowie relativ lange Leiter.

Aus der EP-A-0 315 976 ist ein Strombegrenzer bekannt, bei dem supraleitende Drähte mäanderförmig gebogen, beidseits eines Isolators in dessen Aussparungen angeordnet und elektrisch in einem Stapel mit mehreren Isolatoren in Reihe geschaltet sind. Dabei kompensieren sich die magnetischen Wirkungen eines Stromes durch am Isolator gegenüberliegende Mäander in deren oberer und unterer Halbschleife sowie an den seitlichen Mäanderabschnitten nicht, vgl. dort Fig. 5.

Zum einschlägigen Stand der Technik wird zusätzlich auf die EP-A1-0 406 636 verwiesen. Dort ist zur Begrenzung von Überströmen in einer elektrischen Leitung eines Wechselstromkreises, z. B. infolge eines Kurzschlusses, ein Strombegrenzer vorgesehen, bei dem eine Drosselspule in einem Parallelzweig zu einem Hochtemperatursupraleiter geschaltet ist. Der Supraleiter ist innerhalb der Drosselspule angeordnet und zusätzlich parallel zu einem nichtsupraleitenden Nebenschlußwiderstand geschaltet.

DARSTELLUNG DER ERFINDUNG

Die Erfindung, wie sie im Patentanspruch 1 definiert ist, löst die Aufgabe, eine Vorrichtung zur Strombegrenzung der eingangs genannten Art derart weiterzuentwickeln, daß sie zur resistiven Begrenzung sowohl von Gleich- als auch von Wechselströmen geeignet ist. Ein Überstrom im Falle eines Kurzschlusses soll auf ein vorgebbares Vielfaches des Nennstromes begrenzt werden.

Vorteilhafte Ausgestaltungen der Erfindung sind in den abhängigen Patentansprüchen definiert.

Ein Vorteil der Erfindung besteht darin, daß die Vorrichtung zur Strombegrenzung einfach und kompakt ist. Der supraleitende Teil des Strombegrenzers ist modular aufgebaut, d. h., der Supraleiter ist in Einheiten unterteilt, die im Bedarfsfall separat entfernt und ausgewechselt werden können.

Gemäß einer vorteilhaften Ausgestaltung der Erfindung können die im Strombegrenzer verwendeten Leiterverbunde aus Supraleitern und Normalleitern induktionsarm angeordnet sein. Durch eine geeignete Leiteranordnung können bei Wechselstromanwendungen auftretende Wechselstromverluste stark reduziert werden.

Die Vorrichtung zur Strombegrenzung kann auch als aktives Schaltelement eingesetzt werden, indem sie in ein externes Magnetfeld gebracht wird. Dabei wird die Tatsache ausgenutzt, daß der kritische Strom in Magnetfeldern sehr stark reduziert wird. Durch Einschalten des externen Magnetfeldes kann daher der Strom im Supraleiter auf einen Bruchteil des Nennstromes gebracht werden.

KURZE BESCHREIBUNG DER ZEICHNUNGEN

Die Erfindung wird nachstehend anhand von Ausführungsbeispielen erläutert. Es zeigen:

Fig. 1          eine modulare Anordnung von Strombegrenzern in einer Magnetfeldspule im Querschnitt,

Fig. 2            einen Strombegrenzer gemäß Fig. 1 im Querschnitt,

Fig. 3            einen Supraleiter des Strombegrenzers gemäß Fig. 2 mit mäanderfömiger Leiterbahn in einem Querschnitt,

Fig. 4            Signaldiagramme von Wechselstromverlusten mit Strombegrenzern und

Fig. 5 - 8        Strombegrenzer mit unterschiedlichen Schichtenfolgen.

WEGE ZUR AUSFÜHRUNG DER ERFINDUNG

In den Figuren sind gleiche Teile mit gleichen Bezugszeichen gekennzeichnet.

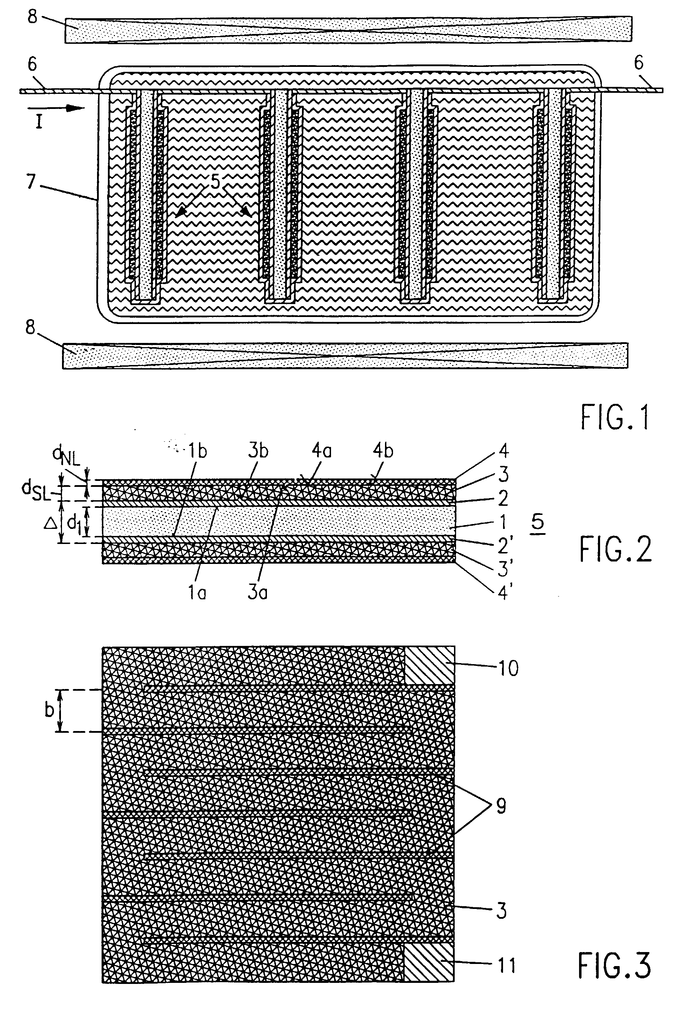

Fig. 1 zeigt in einem mit flüssigem Stickstoff gefüllten Kryostat (7) 4 zueinander parallel angeordnete Strombegrenzer bzw. Strombegrenzermodule (5), die elektrisch in Reihe geschaltet und an eine Stromleitung (6) angeschlossen
sind. Im Betrieb fließt ein Strom (I) durch die Stromleitung (6), der im Falle eines Überstromes, z. B. infolge eines
Kurzschlusses, durch die Strombegrenzermodule (5) auf das 3fache - 5fache eines vorgebbaren Nennstromes ($I_N$)
begrenzt werden soll. Der Kryostat (7) ist innerhalb einer Magnetfeldspule (8) angeordnet.

Fig. 2 zeigt den Schichtaufbau eines Strombegrenzermoduls (5) gemäß Fig. 1. Auf einer 1. Hauptfläche (Ia) sowie
auf einer dieser gegenüberliegenden 2. Hauptfläche (1b) einer scheibenförmigen Keramikplatte bzw. eines Isolators
(1) mit einer Dicke ($d_1$) ist jeweils eine dünne Pufferschicht (2) aus Silber aufgebracht, deren Dicke im Bereich von 1
µm - 5 µm liegt. Als Materialien für den Isolator (1) kommen plattenförmig erhältliche Isolatoren in Frage, die über eine
genügende thermische Stabilität verfügen und zwischen Zimmertemperatur und 77 K eine thermische Langzeitänderung besitzen, welche derjenigen des Supraleiters (3, 3') vergleichbar ist. Vorzugsweise werden glasfaserverstärkte
Gießharzplatten oder MgO-Keramikplatten verwendet. Ihre Aufbringung auf die Pufferschicht (2) erfolgt am einfachsten
mittels eines handelsüblichen Klebstoffes. Dieser Schritt ist erforderlich für Supraleiterplatten (3, 3'), die in einer Silberform geschmolzen wurden, welche nach dem Schmelzen entfernt wird; er entfällt bei Verwendung von Schmelzsubstraten auf einer Nickelbasislegierung oder Keramik, die nach der Herstellung des Supraleiters (3, 3') nicht entfernt
werden müssen und als mechanische Stabilisierung für diesen dienen können.

Auf die beiden Pufferschichten (2) sind, in flächenhaftem Kontakt mit diesen, scheibenförmige Hochtemperatursupraleiter bzw. Supraleiter (3, 3') mit rechteckigem Querschnitt und mäanderförmiger Gestalt gemäß Fig. 3 und einer
jeweiligen Dicke ($d_{SL}$) aufgebracht. Dabei ist eine 1. Hauptfläche (3a) jedes Supraleiters (3, 3') zu dessen elektrischen
Stabilisierung in elektrisch gutleitendem Kontakt mit der jeweiligen Pufferschicht (2). Die beiden Supraleiter (3, 3')
haben einen gegenseitigen Schichtabstand bzw. Leiterabstand ($\Delta$).

Eine 2. Hauptfläche (3b) des jeweiligen Supraleiters (3, 3') steht, zu dessen elektrischen und thermischen Stabilisierung, in einem flächenhaften, gutleitenden elektrischen Kontakt mit einer 1. Hauptfläche (4a) jeweils eines nichtsupraleitenden Widerstandes bzw. Normalleiters (4, 4') mit einer Dicke ($d_{NL}$). Eine der 1. Hauptfläche (4a) gegenüberliegende 2. Hauptfläche des Normalleiters (4, 4') ist mit (4b) bezeichnet. Als Metalle für die Normalleiter (4, 4') eignen
sich besonders solche mit einem spezifischen Widerstand bei Zimmertemperatur von > 10 µΩ cm, die bei - 200 °C
noch duktil sind. In Betracht kommen vorzugsweise: Zinn, Zink, Wismut und deren Legierungen sowie nichtmagnetische Metalle auf Stahl- oder Nickelbasis. Die Normalleiter (4, 4') können durch galvanische Verfahren, Flammenspritzen, Plasmaspritzen, Aufkleben mit einem leitenden Kleber, Auflöten oder Aufsintern eines kalt aufgespritzten Metallpulvers auf den Supraleiter (3, 3') aufgebracht werden. Die Dicke der Schicht des Normalleiters (4, 4') sollte so sein,
daß der elektrische Widerstand dieser Schicht etwa gleich groß ist wie derjenige der Schicht des angrenzenden Supraleiters (3, 3') in nichtsupraleitendem Zustand, z. B. 50 µm bei einer Dicke ($d_{SL}$) des Supraleiters (3, 3') von 1 mm.
Ein flächenbezogener spezifischer Kontaktwiderstand zwischen der 2. Hauptfläche (3b) der Supraleiter (3, 3') und der
1. Hauptfläche (4a) der Normalleiter (4, 4') sollte < 1 mΩ cm$^2$, vorzugsweise ≤ 10 µΩ cm$^2$ sein.

Fig. 3 zeigt einen Querschnitt durch den Supraleiter (3) gemäß Fig. 2 in einem senkrechten Schnitt bezüglich der
Schichtendarstellung in Fig. 2. Durch Einschnitte bzw. Mäanderaussparungen (9) in eine rechteckig, vorzugsweise
quadratisch begrenzte Platte wird ein bandförmiger Leiter hergestellt. Endseitig sind auf diesem Leiter, zu dessen
elektrischen Kontaktierung, Silberkontakte (10, 11) aufgebracht. Benachbarte Mäanderaussparungen (9) haben einen
senkrechten Abstand (b), entsprechend einer Mäanderstegbreite. Die Herstellung der Mäander geschieht am einfachsten durch wechselseitige Einschnitte durch Fräsen oder Sägen oder Laser- oder Wasserstrahlschneiden; sie kann
vor dem Aufbringen des Normalleiters (4, 4') und auch vor dem Aufbringen der mechanischen Stabilisierung, d. h. des
Isolators (1), erfolgen.

Die mäanderförmigen Supraleiter (3, 3') sind in den Strombegrenzermodulen (5) beidseits des Isolators (1) so
angeordnet, daß in jeweils gegenüberliegenden Mäanderstegen der Strom (I) in entgegengesetzter Richtung fließt,
so daß sich die zur Bandebene senkrechten Komponenten des Eigenfeldes gegenseitig kompensieren. Damit wird
erreicht, daß die Strombegrenzermodule (5) niederinduktiv und verlustarm sind.

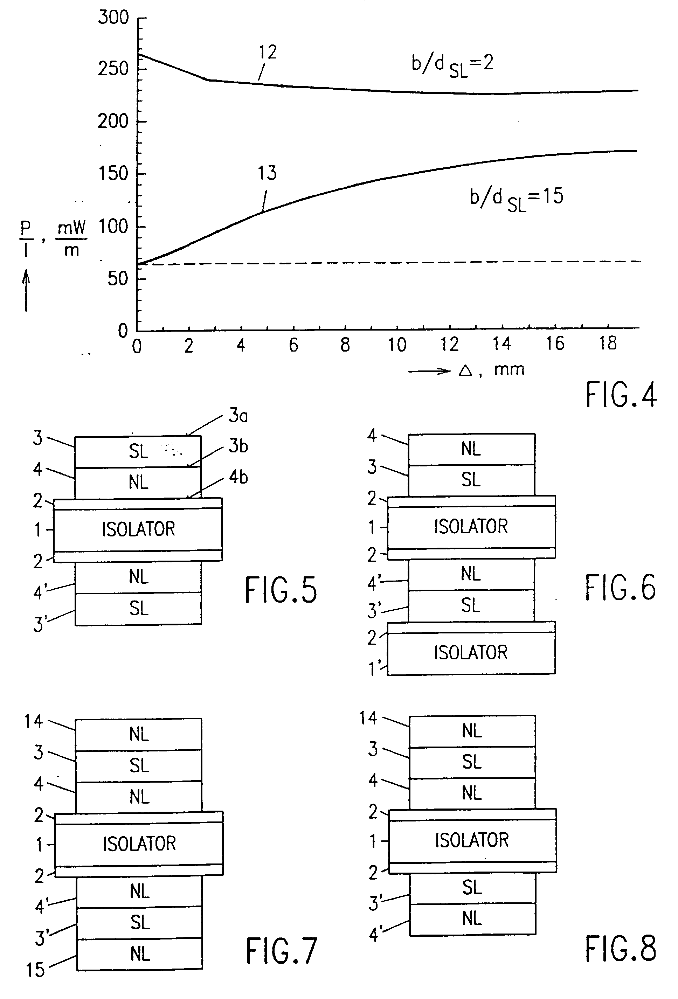

Fig. 4 zeigt in Wechselstrom-Verlustkurven (12) bzw. (13) für unterschiedliche Verhältniswerte von Mäanderstег-
breite (b) zur Dicke ($d_{SL}$) des Supraleiters (3, 3') die Wechselstromverluste, die bei der o. g. Stromrückleitung auftreten.
Dabei sind auf der Abszisse der Leiterabstand ($\Delta$) in mm und auf der Ordinate das Verhältnis von elektrischer Wechselstromverlustleistung (P) zu einer Leiterlänge (1) des Supraleiters (3, 3') in mW/m aufgetragen. Man erkennt aus der Wechselstrom-Verlustkurve (12), daß für $b/d_{SL} = 2$ die Wechselstromverluste mit zunehmendem Leiterabstand ($\Delta$) abnehmen, während sie bei $b/d_{SL} = 15$ mit zunehmendem Leiterabstand ($\Delta$) zunehmen, vgl. die Wechselstrom-Verlustkurve (13). Die Stromrückführungsanordnung in einem Strombegrenzermodul (5) führt mit zunehmendem Leiterabstand ($\Delta$) nur dann zu einer Reduktion der Verluste, wenn das Mäanderband des Supraleiters (3, 3') genügend flach ist, d. h., wenn das Verhältnis $b/d_{SL}$ genügend groß ist, bis zu einem kritischen Wert von 3,5. Für Bänder mit $b < 3,5 \cdot d_{SL}$ erhöht die Stromrückführung die Wechselstromverlustleistung (P), anstatt sie zu reduzieren.

Die Fig. 5 - 8 zeigen in vereinfachter Darstellung unterschiedliche Schichtfolgen, die anstelle des Schichtaufbaus von Fig. 2 verwendet werden können. Dabei sind mit (NL) Normalleiter (4, 4', 14, 15) und mit (SL) Supraleiter (3, 3') bezeichnet.

Gemäß Fig. 5 kann ein Leiterverbund bzw. Schichtenverbund aus einem Normalleiter (4, 4') und einem Supraleiter (3, 3') derart flächenhaft mit dem Isolator (1) bzw. der jeweiligen Pufferschicht (2) verbunden sein, daß jeweils der Normalleiter (4, 4') isolatorseitig angeordnet ist.

Gemäß Fig. 6 kann ein Leiterverbund aus einem Normalleiter (4, 4') und einem Supraleiter (3, 3') derart flächenhaft mit dem Isolator (1) bzw. der jeweiligen Pufferschicht (2) verbunden sein, daß der Isolators (1) mit einer seiner Hauptflächen mit dem Supraleiter (3) in Flächenkontakt steht, entsprechend der Anordnung von Fig. 2, und mit seiner anderen Hauptfläche mit einem Normalleiter (4'), entsprechend der Anordnung von Fig. 5. Zusätzlich kann ein weiterer Isolators (1') vorgesehen sein, der über eine Pufferschicht (2) mit dem Supraleiter (3') in flächenhafter Verbindung steht.

Fig. 7 zeigt einen Schichtaufbau gemäß Fig. 5, bei dem die Außenflächen der Supraleiter (3, 3') mit zusätzlichen Normalleitern (14) bzw. (15) in flächenhaftem, elektrisch gutleitendem Kontakt sind.

Fig. 8 zeigt ein Strombegrenzermodul (5), das auf einer Seite des Isolators (1) einen Schichtaufbau gemäß Fig. 7 und auf der anderen Seite einen Schichtaufbau gemäß Fig. 2 aufweist.

In den Strombegrenzermodulen (5) gemäß Fig. 1 sind die Supraleiter (3, 3') resistiv in einen elektrischen Stromkreis eingekoppelt. Unterhalb einer gewissen kritischen Stromstärke ($j_C$) ist der Supraleiter (3, 3') im supraleitenden Zustand und zeigt daher praktisch keinen elektrischen Widerstand. Wird die kritische Stromstärke z. B. auf Grund eines Kurzschlusses überschritten, so geht der Supraleiter (3, 3') in seinen normalleitenden Zustand über. Der dadurch entstehende Widerstand begrenzt den Strom auf einen gegenüber dem Kurzschlußstrom viel kleineren Wert.

Wichtig sind die Dimensionierung des Supraleiters (3, 3'), dessen elektrische, thermische und mechanische Stabilisierung, die beim Betrieb resultierenden Wechselstromverluste und die Verbindungen zwischen den Strombegrenzermodulen (5).

Die elektrische und thermische Stabilisierung wird durch mindestens einen Normalleiter (4, 4', 14, 15) als Parallelleiter erreicht, der lokal in gutem elektrischem und thermischem Kontakt zum Supraleiter (3, 3') sein muß. Dieser Beipaßwiderstand (4, 4', 14, 15) kann im Bedarfsfall lokal einen Teil des Stromes vom Supraleiter (3, 3') übernehmen und diesen dadurch vor zu starker Erhitzung und Zerstörung schützen. Damit der Supraleiter (3, 3') wirkungsvoll entlastet werden kann, darf der Beipaßwiderstand (4, 4', 14, 15) nicht größer sein als der Normalwiderstand des Supraleiters (3, 3'). Folglich muß die Dicke ($d_{NL}$) des Beipaßwiderstandes $(4, 4', 14, 15) \geq d_{SL} \cdot \rho_{NL}/\rho_{SL}$ sein, wobei $\rho_{NL}$ und $\rho_{SL}$ die spezifischen Widerstände des Beipaßwiderstandes (4, 4', 14, 15) bzw. des Supraleiters (3, 3') bedeuten. Da. der Beipaßwiderstand (4, 4', 14, 15) möglichst viel Wärme aufnehmen sollte, ist man an einer großen thermischen Masse und folglich an einem hohen spezifischen Widerstand $\rho_{NL}$ interessiert.

Im Betriebszustand muß der Supraleiter (3, 3') den Nennstrom ($I_N$) tragen können, was eine untere Grenze für seine Querschnittsfläche F ergibt gemäß:

$$F \geq 1,414 \cdot I_N/j_C.$$

Im Begrenzungszustand soll der Strom (I) höchstens auf das n-fache des Nennstromes ($I_N$) anwachsen, wobei in der Praxis Werte zwischen 3 und 5 gefordert werden. Diese Forderung ergibt die minimale Leiterlänge (1) des Supraleiters (3, 3') gemäß:

$$1 \geq b \cdot (d_{SL}/_{SL} + d_{NL}/\rho_{NL}) \cdot 1,414 \cdot U_N/(n \cdot I_N),$$

wobei $U_N$ die Nennspannung einer nicht dargestellten Stromquelle und b die Streifenbreite eines Leiterverbundes aus Beipaßwiderstand (4, 4', 14, 15) und Supraleiter (3, 3') bedeuten.

Die Wechselstromverlustleistung (P) eines stromdurchflossenen Supraleiters (3, 3') hängt stark vom lokalen Magnetfeld (Eigenfeld und etwaige externe Felder) ab. Bei bandförmigen Supraleitern (3, 3'), wie sie gemäß Fig. 1 verwendet werden, wirken sich vor allem die zur Bandebene senkrecht stehenden Feldkomponenten bezüglich der Wechselstromverlustleistung (P) sehr ungünstig aus. Die Leitergeometrie muß deshalb so beschaffen sein, daß das Feld im Supraleiter (3, 3') hauptsächlich parallel zur Bandebene orientiert ist. In einem einzelnen stromtragenden dünnen Band steht das Magnetfeld im Leiter großenteils senkrecht auf der Bandebene, wobei die Wechselstromverlustleistung (P) für die Anwendung nicht akzeptabel wäre. Eine effiziente Reduktion der senkrechten Feldkomponenten läßt sich mit einer Leitergeometrie erreichen, die aus Paaren von senkrecht zur Bandebene eng benachbarten Leitersegmenten mit antiparallelem Strom (I) besteht. Für jedes Paar solcher Leiter liegt das Magnetfeld im Leiter zum großen Teil parallel zur Bandebene, was eine-wesentlich kleinere Wechselstromverlustleistung (P) zur Folge hat. Die Wechselstromverlustleistung (P) pro Leiterlänge (1) ist gegeben durch:

$$P/1 = 4 \cdot j_c \cdot [-A(x_{ez}) \cdot F + \int A(x) \, df],$$

wobei A(x) das Vektorpotential beim Maximalstrom, $x_{ez}$ das sog. elektrische Zentrum des supraleitenden Bandes, in welchem das elektrische Feld stets = 0 ist, und F die Querschnittsfläche des Bandes bedeuten. Das Integral erstreckt sich über den gesamten Leiterquerschnitt F. Aus der obigen Formel zeigt sich, daß das Stromrückführungskonzept wirksam wird, wenn der Leiterabstand (Δ) der Supraleiter (3, 3') senkrecht zur Bandebene wesentlich kleiner ist als die Mäanderstegbreite (b). Für Δ » b verhalten sich die Supraleiter (3, 3') wie 2 einzelne Leiter mit hoher Wechselstromverlustleistung (P). Für b = 2 mm und $d_{SL}$ = 0,5 mm läßt sich mit Stromrückführung eine Reduktion der Wechselstromverlustleistung (P) um einen Faktor 2 erreichen. Realisieren läßt sich das Stromrückführungskonzept mit mäander- oder spiralförmig angeordneten Bändern, vgl. Fig. 3. Dabei wird der Leiterabstand (Δ) vorzugsweise < 10 mm gewählt.

Beispiel 1 mit Schichtaufbau gemäß Fig. 2:

| | |
|---|---|
| Nennleistung $P_N$ | 20 kW, |
| Nennspannung $U_N$ | 200 V, |
| Nennstrom $I_N$ | 100 A, |
| Maximalstrom $I_{max}$ | 300 A, |
| krit. Stromdichte $j_c$ | 1kA/cm$^2$, |
| Breite des Leiters b | 1,4 cm, |
| Breite der Mäanderaussparungen (9) | 1 mm, |
| Leiterlänge 1 pro Modul (5) | 126 cm, |
| Gesamtleiterlänge | 8,8 m, |
| Anzahl Module (5) | 7, |
| Wechselstromverlustleistung P bei 77 K | 0,62 W. |

Ein modular aufgebauter Hochtemperatursupraleiter (3, 3') auf der Basis Bi : Sr : Ca : Cu = 2 : 2 : 1 : .2 wurde in einer Dicke ($d_{SL}$) von 1 mm auf eine Keramikplatte (1) mit einer Fläche von 10 cm · 10,4 cm und einer Dicke ($d_1$) von 1 mm beidseitig aufgebracht. Zwischen der Keramikplatte (1) und dem Supraleiter (3, 3') befand sich eine Silberschicht (2) mit einer Dicke von 2 μm. Das Silber wirkt gleichzeitig als elektrischer Stabilisator (Beipaßwiderstand) und als chemischer Isolator zwischen dem Supraleiter (3, 3') und dem Keramiksubstrat (1). Auf der anderen Seite des Supraleiters (3, 3') war eine Bleischicht (4, 4') mit einer Dicke ($d_{NL}$) von 10 μm aufgebracht, die ebenfalls zur elektrischen Stabilisierung beiträgt.

Aus der supraleitenden Schicht wurden von beiden Seiten der Platte Mäanderaussparungen (9) gemäß Fig. 3 geschnitten. Die 2 Leiterbahnen (3, 3') auf beiden Seiten der Keramikplatte (1) sind elektrisch so miteinander verbunden, daß der Strom (I) in direkt einander gegenüberliegenden Teilbändern antiparallel fließt. Dadurch wird der Stromrückführungseffekt für die Reduktion der Wechselstromverlustleistung (P) erzielt.

Beispiel 2: Schalterfunktion gemäß Fig. 1

Indem man die Strombegrenzermodule (5) gemäß Beispiel 1 mit einer Magnetfeldspule (8) umschließt, wie in Fig. 1 dargestellt, kann die erfindungsgemäße Vorrichtung als aktives Schaltelement eingesetzt werden. Beim Einschalten des Magnetfeldes wird die kritische Stromstärke ($j_c$) im Supraleiter (3, 3') reduziert, so daß der Supraleiter (3, 3') in den resistiven Zustand übergeht. Dies bewirkt eine Reduktion des Stromes I auf einen Bruchteil des Nennstromes ($I_N$). Auf Grund der Texturierung des Supraleiters (3, 3') ist eine Reduktion der kritischen Stromstärke ($j_c$) dann am stärksten, wenn das angelegte Magnetfeld senkrecht zur Ebene des supraleitenden Bandes steht, wie in Fig. 1.

Herstellung einer supraleitenden Platte (1):

Supraleiterpulver der Zusammensetzung $Bi_aSr_bCa_cCu_dO_e$ mit a, b, d = 1,8 -2,2, c = 0,8 - 1,2, e = 7,5 - 8,5 wird in eine geeignete Flachform trocken oder als Suspension mit einer Flüssigkeit eingefüllt. In einer bevorzugten Ausführungsart wird diesem Supraleiterpulver Silberpulver und/oder $Bi_2O_3$-Pulver in einem Konzentrationbereich von 0,5 % - 5 % zugemischt, wodurch die Aufschmelzung und Kompaktierung der Schmelze positiv beeinflußt wird. Als Schmelzform ist jedes Material geeignet, welches während des darauffolgenden Aufschmelzens des Pulvers nicht mit dem Pulver reagiert und bei Temperaturen um 900 °C formstabil bleibt. Verwendet wurden Formen aus Silberblech, aus Nickellegierungen mit einer Schutzschicht aus Silber und Keramikplatten aus Magnesiumoxid und stabilisiertem Zirkonoxid. Die Metallformen konnten leicht, z. B. durch Tiefziehen oder Falten, mit einem Rand von ca. 10 mm Höhe versehen werden. Als Pufferschicht (2) bzw. Klebemittel wurde Leitsilber verwendet. Die Füllhöhe wurde so gewählt, daß bei 100 %iger Kompaktierung des Pulvers durch das Aufschmelzen eine Dicke ($d_{SL}$) von 0,3 mm - 3 mm resultiert. Vorteilhaft für die erzielbare Stromdichte und Homogenität ist eine möglichst hohe sog. Gründichte des Pulvers, welche durch uniaxiales Nachpressen des lockeren Pulverbettes erreicht wurde. Dabei ist ein Preßdruck von 10 MPa ausreichend. Das Schmelzverfahren ist in der DE-A1-4 234 311 beschrieben.

Aufbringen der elektrischen Stabilisierung:

Supraleiterplatten (1), welche in Silber- oder Keramikformen hergestellt wurden, hat man mit einer Metallisierung (4, 4', 14, 15) versehen, welche als elektrische Stabilisierung dient. Hierzu muß das Silber von der Supraleiterplatte (1) entfernt werden, was vor der Metallisierung oder nach einem Aufbringen einer mechanischen Stabilisierung geschehen kann.

Bei Verwendung von Schmelzformen aus versilberter Nickelbasislegierung kann auf eine separate elektrische Stabilisierung verzichtet werden, wenn der Widerstand der Kombination Silber - Nickelbasislegierung schon demjenigen des Supraleiters (3, 3') entspricht.

Beispiel 3:

Aus einem 100 µm dicken Silberblech wurden quadratische Schmelzformen mit Abmessungen von 100 mm 100 mm mit Rändern von 6 mm Höhe von Hand gefalzt. Diese Schmelzformen wurden jeweils mit einer Aufschlämmung von 60 g Pulver $Bi_2Sr_2Ca_1Cu_2O_{8+\delta}$ in Äthanol gefüllt, $0 \leq \delta \leq 0,3$. Nach dem Eintrocknen der Flüssigkeit wurde das Pulverbett durch uniaxiales Pressen mit einem Druck von 2 GPa verdichtet. Die Proben wurden dann einer Wärmebehandlung in Sauerstoffatmosphäre unterworfen, welche aus einem Aufschmelzschritt bei 900 °C während einer Dauer im Bereich von 20 h - 80 h bestand. Im Ergebnis wurden homogene, kompakte Supraleiterplatten (3, 3') von ca. 1 mm Dicke erhalten, von welchen sich das Silber leicht abschälen ließ. Auf diese Supraleiterplatten (3, 3') wurde mittels Flammenspritzen zur elektrischen Stabilisierung eine 50 µm dicke Zinnschicht abgeschieden. Diese Supraleiterplatten (3, 3') wurden dann auf ein Aluminiumblech geklebt und mittels Wasserstrahlschneiden mäandriert, wodurch Leiter mit einem Querschnitt von 14 mm · 1 mm und einer Lange von ca. 70 cm entstanden. Nach einem Ablösen vom Aluminiumblech wurden jeweils 2 Supraleiterplatten (3, 3') so gegeneinander ausgerichtet, daß deren Bahnen auf der Vorder- und Rückseite der Keramikplatte (1) parallel verlaufen und die Enden mit den Silberkontakten (10, 11) übereinander liegen. Die Silberkontakte (10, 11) sind mit einem silbergefüllten Epoxidharzkleber aufgeklebt; durch sie können die Enden niederohmig in Reihe geschaltet werden. Der spezifische Kontaktwiderstand der Verklebung mit silbergefülltem Epoxidharz beträgt 0,05 $\mu\Omega$ cm². Bei einem Strom (I) von 1 kA baute das Strombegrenzermodul (5) einen Widerstand von 5 $\Omega$ auf.

Zweckmäßig ist es, das Verhältnis von Leiterabstand ($\Delta$) zu Mäanderstegbreite (b) eines Strombegrenzermoduls (5) < 0,5, vorzugsweise < 0,1 zu wählen.

BEZEICHNUNGSLISTE

| | |
|---|---|
| 1, 1' | Isolatoren, Keramikplatten |
| 1a, 1b | 1. bzw. 2. Hauptfläche von 1, 1' |
| 2 | Pufferschicht, Silberschicht |
| 3, 3' | Supraleiter, Hochtemperatursupraleiter |
| 3a, 3b | 1. bzw. 2. Hauptfläche von 3, 3' |
| 4, 4', 14, 15 | nichtsupraleitende Widerstände, Nebenschlußwiderstände zu 3, 3' |
| 4a, 4b | 1. bzw. 2. Hauptfläche von 4, 4' |
| 5 | Strombegrenzermodul, Strombegrenzer |
| 6 | Stromleitung |

| 7 | Kryostat |
|---|---|
| 8 | Magnetfeldspule |
| 9 | Mäanderaussparungen |
| 10, 11 | Silberkontakte |
| 12, 13 | Wechselstrom-Verlustkurven |

| b | Mäanderstegbreite, Breite der Leiterbahn von 3, 3', Streifenbreite eines Leiterverbundes |
|---|---|
| $d_{NL}$ | Dicke von 4, 4', 14, 15 |
| $d_{SL}$ | Dicke von 3, 3' |
| $d_1$ | Dicke von 1 |
| I | Strom |
| l | Leiterlänge |
| NL | Normalleiter |
| P | elektrische Wechselstromverlustleistung |
| SL | Supraleiter |
| $\Delta$ | Leiterabstand, Schichtabstand der SL |

**Patentansprüche**

1. Vorrichtung zur Strombegrenzung

   a) mit mindestens einem Supraleiter (3, 3') und
   b) mit mindestens einem nichtsupraleitenden Nebenschlußwiderstand (4, 4', 14, 15) parallel zum Supraleiter (3, 3'),
   c) wobei der Supraleiter (3, 3') über mindestens eine 1. Hauptfläche (3b) flächenhaften Kontakt mit einer Hauptfläche (4a) eines Nebenschlußwiderstandes (4, 4', 14, 15) hat und mit diesem einen Leiterverbund bildet und
   d) sowohl eine erste Hauptfläche (1a) als auch
   e) eine dieser gegenüberliegende zweite Hauptfläche (1b) eines Isolators (1, 1') mit jeweils einem Leiterverbund aus einem Supraleiter (3, 3') und einem Nebenschlußwiderstand (4, 4', 14, 15) in flächenhaftem Kontakt steht,

   dadurch gekennzeichnet,

   f) daß jeder Leiterverbund als mäanderförmiges Band ausgebildet ist,
   g) daß auf beiden Hauptflächen (1a, 1b) des Isolators (1) angeordnete Leiterverbunde elektrisch in Reihe geschaltet und
   h) spiegelbildlich zueinander angeordnet sind, derart, daß ein Strom (I) in direkt einander gegenüberliegenden Bändern der Leiterverbunde antiparallel fließt,
   i) daß eine Mäanderstegbreite (b) des mäanderförmigen Bandes $> 3{,}5 \cdot d_{SL}$ ist, $d_{SL}$ = Dicke des Supraleiters (3, 3'), und
   j) daß das Verhältnis von einem Leiterabstand ($\Delta$) 2er direkt einander gegenüberliegenden Supraleiter (3, 3') eines Strombegrenzermoduls (5) zu einer bzw. der Mäanderstegbreite (b) der Supraleiter (3, 3') $< 0{,}5$ ist.

2. Vorrichtung nach Anspruch 1, dadurch gekennzeichnet, daß die Mäanderstegbreite (b) des mäanderförmigen Bandes $> 10 \cdot d_{SL}$ ist, $d_{SL}$ = Dicke des Supraleiters (3, 3').

3. Vorrichtung nach einem der vorherigen Ansprüche, dadurch gekennzeichnet, daß das Verhältnis von einem Leiterabstand ($\Delta$) 2er Supraleiter (3, 3') eines Strombegrenzermoduls (5) zu einer bzw. der Mäanderstegbreite (b) der Supraleiter (3, 3') $< 0{,}1$ ist.

4. Vorrichtung nach einem der vorherigen Ansprüche, dadurch gekennzeichnet, daß der Supraleiter (3') eines Leiterverbundes über eine seiner beiden Hauptflächen mit einer Hauptfläche eines weiteren Isolators (1') in flächenhaftem Kontakt steht.

5. Vorrichtung nach einem der vorherigen Ansprüche, dadurch gekennzeichnet,

a) daß der elektrische Widerstand eines Nebenschlußwiderstandes (4, 4', 14, 15) nicht größer ist als der elektrische Widerstand des mit ihm verbundenen Supraleiters (3, 3') in seinem nichtsupraleitenden Zustand und

b) daß für eine minimale Leiterlänge 1 des Supraleiters (3, 3') gilt:

$$1 \geq b \cdot (d_{SL}/\rho_{SL} + d_{NL}/\rho_{NL}) \cdot 1{,}414 \cdot U_N/(n \cdot I_N),$$

wobei $d_{SL}$ die Dicke des Supraleiters (3, 3'), $d_{NL}$ die Dicke des Nebenschlußwiderstandes (4, 4', 14, 15), $\rho_{SL}$ und $\rho_{NL}$ die spezifischen Widerstände des Supraleiters (3, 3') bzw. des Nebenschlußwiderstandes (4, 4', 14, 15), IN den Nennstrom, n das Verhältnis von zulässigem Maximalstrom zu $I_N$, $U_N$ die Nennspannung einer Stromquelle und b die Streifenbreite eines Leiterverbundes aus Beipaßwiderstand (4, 4', 14, 15) und Supraleiter (3, 3') bedeuten.

## Claims

1. Current limiter device

   a) having at least one superconductor (3, 3') and
   b) having at least one non-superconducting shunt resistor (4, 4', 14, 15) in parallel with the superconductor (3, 3'),
   c) the superconductor (3, 3') having, via at least a first main face (3b), extensive contact with a main face (4a) of a shunt resistor (4, 4', 14, 15) and forming a compound conductor with the latter, and
   d) a first main face (1a) and
   e) a second main face (1b) of an insulator (1, 1'), which is opposite the first main face and is in extensive contact in each case with a compound conductor consisting of a superconductor (3, 3') and a shunt resistor (4, 4', 14, 15),

   characterized in that

   f) each compound conductor is designed as a band with a meander shape,
   g) in that compound conductors arranged on both main faces (1a, 1b) of the insulator (1) are electrically connected in series and
   h) are arranged with mirror symmetry in such a way that a current (I) flows in antiparallel directions in directly opposite bands of the compound conductors,
   i) in that a meander path width (b) of the band with a meander shape is $> 3.5 \cdot d_{SC}$, $d_{SC}$ = thickness of the superconductor (3, 3'), and
   j) in that the ratio of a conductor separation (A) of two directly opposite superconductors (3, 3') of a current limiter module (5) to a or the meander path width (b) of the superconductors (3, 3') is $< 0.5$.

2. Device according to Claim 1, characterized in that the meander path width (b) of the band with a meander shape is $> 10 \cdot d_{sc}$, $d_{sc}$ = thickness of the superconductor (3, 3').

3. Device according to one of the preceding claims, characterized in that the ratio of a conductor separation ($\Delta$) of two superconductors (3, 3') of a current limiter module (5) to a or the meander path width (b) of the superconductors (3, 3') is $< 0.1$.

4. Device according to one of the preceding claims, characterized in that the superconductor (3') of a compound conductor is in extensive contact, via one of its two main faces, with a main face of a further insulator (1').

5. Device according to one of the preceding claims, characterized in that

   a) the electrical resistance of a shunt resistor (4, 4', 14, 15) is not greater than the electrical resistance, in its non-superconducting state, of the superconductor (3, 3') connected to it, and
   b) in that the following inequality is satisfied for a minimum conductor length l of the superconductor (3, 3'):

$$1 \geq b \cdot (d_{SC}/\rho_{SC} + d_{NC}/\rho_{NC}) \cdot 1.414 \cdot U_R/(n \cdot I_R),$$

$d_{SC}$ being the thickness of the superconductor (3, 3'), $d_{NC}$ being the thickness of the shunt resistor (4, 4', 14, 15), $\rho_{SC}$ and $\rho_{NC}$ being the resistivities of the superconductor (3, 3') and of the shunt resistor (4, 4', 14, 15) respectively, $I_R$ being the rated current, n being the ratio of the maximum permissible current to $I_R$, $U_R$ being the rated voltage of a current source and b being the strip width of a compound conductor consisting of a bypass resistor (4, 4', 14, 15) and a superconductor (3, 3').

**Revendications**

1. Limiteur de courant

    a) avec au moins un supraconducteur (3, 3') et
    b) avec au moins une résistance de dérivation (4, 4', 14, 15) non supraconductrice en parallèle avec le supraconducteur (3, 3'),
    c) le supraconducteur (3, 3') se trouvant en contact superficiel avec une surface principale (4a) d'une résistance de dérivation (4, 4', 14, 15) par le biais d'au moins une 1$^{\text{ère}}$ surface principale (3b) et formant avec celle-ci un composé conducteur et
    d) aussi bien une première surface principale (1a) que
    e) une deuxième surface principale (1b) d'un isolateur (1, 1'), opposée à celle-ci, étant en contact superficiel à chaque fois avec un composé conducteur constitué d'un supraconducteur (3, 3') et d'une résistance de dérivation (4, 4', 14, 15),

    caractérisé par le fait

    f) que chaque composé conducteur est réalisé sous la forme d'une bande spiralée,
    g) que sur les deux surfaces principales (1a, 1b) de l'isolateur (1), les composés conducteurs qui y sont disposés sont branchés en série et
    h) sont disposés en miroir les uns par rapport aux autres de manière à ce qu'un courant (I) s'écoule dans le sens antiparallèle dans les bandes directement opposées des composés conducteurs,
    i) qu'une largeur de montant de spirale (b) de la bande spiralée est > 3,5 · $d_{SL}$, $d_{SL}$ = épaisseur du supraconducteur (3, 3'), et
    j) que le rapport entre un écart entre les conducteurs (Δ) de deux supraconducteurs (3, 3') directement opposés d'un module limiteur de courant (5) et une ou la largeur du montant de la spirale (b) du supraconducteur (3, 3') est < 0,5.

2. Dispositif selon la revendication 1, caractérisé par le fait que la largeur du montant de la spirale (b) de la bande spiralée est > 10 · $d_{SL}$, $d_{SL}$ = épaisseur du supraconducteur (3, 3').

3. Dispositif selon l'une des revendications précédentes, caractérisé par le fait que le rapport entre un écart entre les conducteurs (Δ) de 2 supraconducteurs (3, 3') d'un module limiteur de courant (5) et une ou la largeur du montant de la spirale (b) du supraconducteur (3, 3') est < 0,1.

4. Dispositif selon l'une des revendications précédentes, caractérisé par le fait que le supraconducteur (3') d'un composé conducteur se trouve en contact superficiel avec une surface principale d'un autre isolateur (1') par le biais de l'une de ses deux surfaces principales.

5. Dispositif selon l'une des revendications précédentes, caractérisé par le fait

    a) que la résistivité électrique d'une résistance de dérivation (4, 4', 14, 15) n'est pas supérieure à la résistivité électrique du supraconducteur (3, 3') qui lui est lié dans son état non supraconducteur et
    b) que ce qui suit s'applique pour une longueur de conducteur 1 minimale du supraconducteur (3, 3') :

$$1 \geq b \cdot (d_{SL}/\rho_{SL} + d_{NL}/\rho_{NL}) \cdot 1{,}414 \cdot U_N/(n \cdot I_N),$$

où $d_{SL}$ est l'épaisseur du supraconducteur (3, 3'), $d_{NL}$ est l'épaisseur de la résistance de dérivation (4, 4', 14, 15), $\rho_{SL}$ et $\rho_{NL}$ sont les résistivités spécifiques du supraconducteur (3, 3') ou de la résistance de dérivation (4, 4', 14, 15), $I_N$ est le courant nominal, n le rapport entre le courant maximum toléré et $I_N$, $U_N$ est la tension nominale d'une source de courant et b est la largeur des bandes d'un composé conducteur constitué de la résistance de dérivation (4, 4', 14, 15) et du supraconducteur (3, 3').

FIG.1

FIG.2

FIG.3

FIG.4

FIG.5

FIG.6

FIG.7

FIG.8